(19) Europäisches Patentamt / European Patent Office / Office européen des brevets

(11) **EP 2 879 291 A1**

(12) **EUROPEAN PATENT APPLICATION**

(43) Date of publication:
03.06.2015 Bulletin 2015/23

(51) Int Cl.:
*H03F 1/02* (2006.01)    *H03F 1/56* (2006.01)
*H03F 1/42* (2006.01)    *H03F 3/195* (2006.01)
*H03F 3/24* (2006.01)

(21) Application number: 13194771.5

(22) Date of filing: 28.11.2013

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Nokia Solutions and Networks Oy 02610 Espoo (FI)**

(72) Inventors:
• **Felgentreff, Tilman**
  **83607 Holzkirchen (DE)**
• **Musolff, Christian**
  **91058 Erlangen (DE)**
• **Fischer, Georg**
  **90425 Nürnberg (DE)**

(54) **Broadband RF power amplifier with active load modulation**

(57)    An apparatus is provided which comprises a main amplifier core and at least one auxiliary amplifier core, an input signal splitter connected to the input of the main amplifier core and the input of the at least one auxiliary amplifier core, and an output combiner connected to an output of the main amplifier core and an output of the at least one auxiliary amplifier core. The input signal splitter is configured to split an input signal into a first signal for the main amplifier core and at least a second signal for the at least one auxiliary amplifier core according to frequency dependent nonlinear input drive functions, and the output combiner is configured to combine output signals of the main amplifier core and the at least one auxiliary amplifier core, and to provide a continuum of optimum termination impedances of the main amplifier core for the fundamental frequency and at least one harmonic frequency over a predetermined bandwidth of operation, in a low power region, the low power region being defined by the at least one auxiliary amplifier core being inactive.

Fig. 1

EP 2 879 291 A1

## Description

Field of the Invention

The present invention relates to an apparatus such as a broadband RF power amplifier with active load modulation.

Related backaround Art

The following meanings for the abbreviations used in this specification apply:

BTS　　base station
BW　　bandwidth
RF　　radio frequency

Embodiments of the present invention relate to RF power amplifiers for BTS or Mobile RF transmitter. One of the main research topics industry is to improve is the efficiency of RF power amplification.

The main challenge of RF power amplifier design is to balance the contrasting design targets for efficiency, RF output power and signal BW the amplifier has to support. Additionally the linearity of the RF power amplifier is a major concern, as it has to be kept at a high level in order to be able to fulfill spectral emission mask requirements. Traditional techniques to maximize the efficiency generally deteriorate linearity and are typically not applicable to broadband RF power amplifier designs.

The currently predominant architecture for RF power amplification in mobile base stations is the Doherty architecture in various configurations as: symmetric, asymmetric, 2 or 3 way and also inverted. The Doherty power amplifier consists of minimum two amplifier cores (main and auxiliary) being configured in a way to enable active load modulation. By means of active load modulation, the backoff-efficiency of the power amplifier is improved, which is highly relevant to the overall efficiency of the mobile base station.

Summary of the Invention

Embodiments of the present invention address this situation and aim to provide an RF power amplifier with an improved efficiency while still a broadband design and linearity of the RF power amplifier is ensured.

According to a first aspect of the present invention an apparatus is provided which comprises a main amplifier core and at least one auxiliary amplifier core, an input signal splitter connected to the input of the main amplifier core and the input of the at least one auxiliary amplifier core, and an output combiner connected to an output of the main amplifier core and an output of the at least one auxiliary amplifier core. The input signal splitter is configured to split an input signal into a first signal for the main amplifier core and at least a second signal for the at least one auxiliary amplifier core according to frequency dependent nonlinear input drive functions, and the output combiner is configured to combine output signals of the main amplifier core and the at least one auxiliary amplifier core, and to provide a continuum of optimum termination impedances of the main amplifier core for the fundamental frequency and at least one harmonic frequency over a predetermined bandwidth of operation, in a low power region, the low power region being defined by the at least one auxiliary amplifier core being inactive.

Brief Description of the Drawings

These and other objects, features, details and advantages will become more fully apparent from the following detailed description of embodiments of the present invention which is to be taken in conjunction with the appended drawings, in which:

　　Fig. 1 shows a structure of an RF power amplifier according to an embodiment of the present invention, and

　　Fig. 2 shows a structure of a prior art RF power amplifier in line with Doherty architecture, and

　　Fig. 3 shows an exemplary implementation of the multi-harmonic output combiner according to an embodiment of the present invention.

Detailed Description of embodiments

In the following, description will be made to embodiments of the present invention. It is to be understood, however, that the description is given by way of example only, and that the described embodiments are by no means to be understood as limiting the present invention thereto.

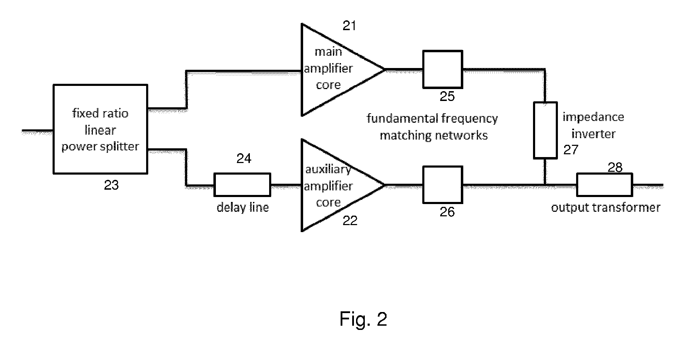

Before describing embodiments of the present invention, however, the problem underlying the present application is summarized again, wherein at first the standard Doherty architecture is described by referring to Fig. 2.

Fig. 2 shows a traditional RF power amplifier in which the Doherty architecture is applied. In detail, the power amplifier comprises a first amplifier, namely a main amplifier core 21, and a second amplifier, namely an auxiliary amplifier core 22. An input signal is split by a fixed ratio linear power splitter 23. That is, the splitter 23 splits the input signal linearly with a fixed ratio (splitting ratio). Between the splitter 23 and peak amplifier core 22, a delay line 24 is provided, by which a phase compensation is effected. An output of the main amplifier core 21 is connected to a first fundamental frequency matching network 25, and an output of the peak amplifier core 22 is connected to a second fundamental frequency matching network 26. The output of the first fundamental frequency matching network 25 is connected to an impedance inverter 27. The outputs of the impedance inverter 27 and of the second fundamental frequency matching network 26 are connected to an input of an output transformer 28.

In the Doherty power amplifier, two different regions can be distinguished, namely a low power region and a high power region. In the low power region, only the main amplifier core operates. In the high power region, both of the main amplifier core and the auxiliary amplifier core operate. In particular, when the main amplifier core reaches its maximum efficiency, the auxiliary amplifier core is turned on, and the virtual load impedances presented to the amplifier cores are varied according to the ratio between the amplifier cores output currents. This process is referred to as active load modulation. In this way, theoretically a high efficiency operation can be maintained throughout the high-power region, which extends from peak power down to a backoff power level of usually around 6dB. The nonlinear, delayed turn-on characteristic of the auxiliary amplifier is traditionally achieved by biasing it in Class C, while the main amplifier is operated linearly in Class AB.

Both amplifier cores are typically operated out of the same supply voltage, although operation at different voltage levels is known to be advantageous in terms of BW, as it minimizes the frequency dependence of the impedance inverter in the output combiner (described for example in Gustafsson, D., Fager, C., patent application WO 2012/149976 A, and in Wu, D.Y., Boumaiza, S., "A Modified Doherty Configuration for Broadband Amplification Using Symmetrical Devices", IEEE Transactions on Microwave Theory and Techniques, Volume 60, Issue 10, Pages 3201 - 3213, 2012). In practical designs, however, the application of different voltage levels alone cannot provide the desired level of BW and efficiency improvement.

For the purpose of achieving efficient wideband RF power amplification, the Class J concept, which is based on a continuous termination of the fundamental and second harmonic frequency component, was established in the last decade (described, for example, in Cripps, S.C., Tasker, P.J., Clarke, A.L., Lees, J., Benedikt, J., "On the Continuity of High Efficiency Modes in Linear RF Power Amplifiers", IEEE Microwave and Wireless Components Letters, Volume 19, Issue 10, Pages 665 - 667, 2009; and Wright, P., Lees, J., Benedikt, J., Tasker, P.J., Cripps, S.C., "A Methodology for Realizing High Efficiency Class-J in a Linear and Broadband PA", IEEE Transactions on Microwave Theory and Techniques, Volume 57, Issue 12, Part 2, 2009). It provides a method for the power amplifier designer to compensate the frequency dependence of the reactive termination component at the fundamental frequency by designing an opposite frequency dependence at the second harmonic frequency. This termination continuum maps to a waveform continuum at the intrinsic drain (or collector) of the active device (e.g., transistor), which features constant output power and constantly high efficiency over the entire range of the continuum.

At the same time it also addresses the problem of finding a wideband termination condition for the second harmonic frequency, as the usually assumed short circuit of this frequency component cannot be achieved over a larger bandwidth (this would violate the Foster theorem).

Thus, by means of the Class J termination continuum, a constantly efficient operation of the power amplifier can be maintained over a largely extended BW.

However, the application of Class J in Doherty amplifiers was not possible previously, since the known realizations of the required continuous termination conditions do not allow for active load modulation.

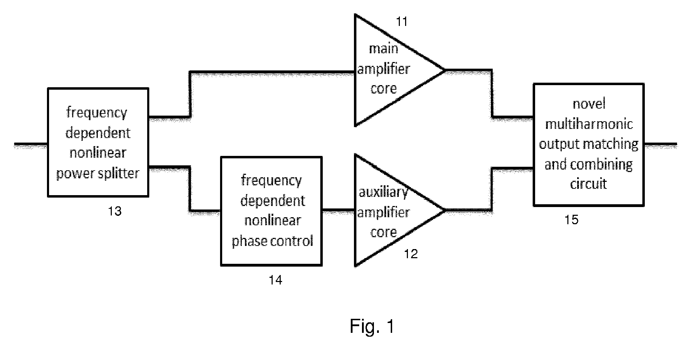

An embodiment according to the present invention provides an RF power amplifier which is based on the Doherty architecture, but output combiner and input splitter are provided such that the desired effects can be achieved, as will be explained in the following by referring to Fig. 1.

In detail, according to the embodiment, an apparatus (e.g., an RF power amplifier) is provided, which comprises a first amplifier (e.g., main amplifier core 11 shown in Fig. 1) and at least one second amplifier (e.g., auxiliary amplifier core 12), an input splitter (e.g., power splitter 13) connected to an input of the first amplifier and an input of the at least one second amplifier, and an output combiner (e.g., multi-harmonic output matching and combining circuit 15) connected to an output of the first amplifier and an output of the at least one second amplifier. The input splitter is configured to split an input signal into a first signal for the first amplifier and at least a second signal for the at least one second amplifier. The output combiner is configured to combine output signals of the main amplifier core and the at least one auxiliary amplifier core, and to provide a continuum of optimum termination impedances of the main amplifier core for the fundamental frequency and at least one harmonic frequency over a predetermined bandwidth of operation, in the a low power region, the low power region being defined by the at least one auxiliary amplifier core being inactive. In this way, it is possible to achieve a highly efficient continuum of termination impedances over the desired bandwidth of operation, in the low power region.

The continuum of optimum termination impedances denotes a continuous space of combinations of termination impedances at several harmonic frequencies which maps to a continuous space of output voltage waveforms at the intrinsic reference plane of the active device (transistor), such that constant output power and optimum efficiency is yielded from this waveforms. For example, based on an ideal model and limited to two harmonic frequency components, such an optimum continuum is given by Class J theory, as described in literature (e.g., in "On the Continuity of High Efficiency Modes in Linear RF Power Amplifiers" and "A Methodology for Realizing High Efficiency Class-J in a Linear and Broadband PA" already mentioned above).

For the input splitter (frequency dependent nonlinear power splitter 13 shown in Fig. 1), specially shaped input drive functions are utilized that can be realized, according to a first embodiment, by using Digital Doherty architecture, this is, moving the input power splitter and phase control into the digital domain, or, according to a second embodiment, by a specific analogue signal processing circuit with the same functionality.

The output combiner is configured to provide a wideband harmonic termination continuum (e.g., Class J) to the active device of the main amplifier core in the low power region, that is, when the auxiliary amplifier is inactive. Thus, very efficient and wideband linear amplification can be achieved in the low power region, which is most significant to the overall efficiency of the power amplifier.

In the high power region, when both amplifier cores are active, the output combiner combines the output signals of the amplifier cores in a way that enables active load modulation, comparable to the Doherty concept. However, under load modulation, the optimum continuous termination condition, (e.g., the optimum ratio between fundamental and second harmonic frequency component reactances) cannot be fully maintained over the entire bandwidth.

Elementary to load modulation is the fact that the virtual termination impedance at the active devices of the amplifier cores is a function of the complex ratio between the output currents of these devices, according to the formulas

$$Z_M = Z_{11} + \frac{Z_{13}^2}{1 - Z_{33}} + \left(Z_{12} + \frac{Z_{13}Z_{23}}{1 - Z_{33}}\right)\vec{\Gamma}$$

expressing the virtual impedance $Z_M$ at the output of the active device of the main amplifier core, and

$$Z_P = Z_{22} + \frac{Z_{23}^2}{1 - Z_{33}} + \left(Z_{12} + \frac{Z_{23}Z_{13}}{1 - Z_{33}}\right)\frac{1}{\vec{\Gamma}}$$

expressing the virtual impedance $Z_P$ at the output of the active device of the auxiliary amplifier core and

$$\vec{\Gamma} = \frac{\overline{I_P}}{\overline{I_M}}$$

denoting the complex ratio between the output currents of the active devices of the amplifier cores. Moreover, $Z_{xy}$ denotes the Z-Parameters of the combiner. In general, Z-parameters are defined for an n-port network as follows:

$$Z_{n,m} = \frac{V_n}{I_m}\bigg|_{I_k = 0 \text{ for } k \neq m}$$

The complex current ratio $\vec{\Gamma} = \frac{\overrightarrow{I_P}}{\overrightarrow{I_M}}$ is controlled by the input drive functions.

Accordingly, the input drive functions can be used to manipulate the virtual impedances at the active devices of the amplifier cores under load modulation in a way that allows to partially mitigate the inherent bandwidth limitation of the combiner under load modulation. Thus, a frequency adaptive implementation of input drive functions, especially with regard to the relative phase between the inputs, reduces the efficiency impairment which is caused by the deviation from the optimum termination continuum (the continuum of optimum termination impedances mentioned above) under load modulation to acceptably low levels and thus enables the practical usage of active load modulation in wideband power amplifiers based on continuous multi-harmonic terminations. This means that it becomes possible for the first time to combine the large BW capabilities of continuous multi-harmonic termination concepts like Class J with the efficiency advantages of Doherty architecture.

In more detail, according to embodiments of the present invention, a novel multi-harmonic combiner circuit 15 is used that provides continuous control of the terminations of amplifier cores for at least 3 harmonic frequencies (similar to Class J), instead of just the fundamental frequency, as is done in today's Doherty amplifiers, and also accounts for load modulation at these frequencies; This results in highly efficient waveform shaping at the intrinsic reference plane of the active devices (transistors) of the amplifier cores over a largely extended BW.

The output combiner circuit implements the required continuous multi-harmonic termination conditions and ability to maintain these under load modulation by utilizing elements of a low-pass structure, such as impedance steps in microstrip transmission lines.

Based on this technique, the impedance inverter can provide the desired impedance inversion at the fundamental frequency band while absorbing the parasitic elements of the main amplifier transistor device and at the same time minimizing transmission of harmonic frequency components between the connected amplifier cores (and therefore minimizing unwanted load modulation effects at the harmonic frequencies) and providing a proper reflection phase (according to the multi-harmonic termination continuum that is used) for at least one harmonic frequency component at the main amplifier core.

Similarly, the output transformer circuit can provide the required impedance transformation at the fundamental frequency band while at the same time minimizing the transmission of harmonic frequency components to the load connected to the RF output and provide a proper reflection phase (according to the multi-harmonic termination continuum that is used) for at least one harmonic frequency component at the auxiliary amplifier core.

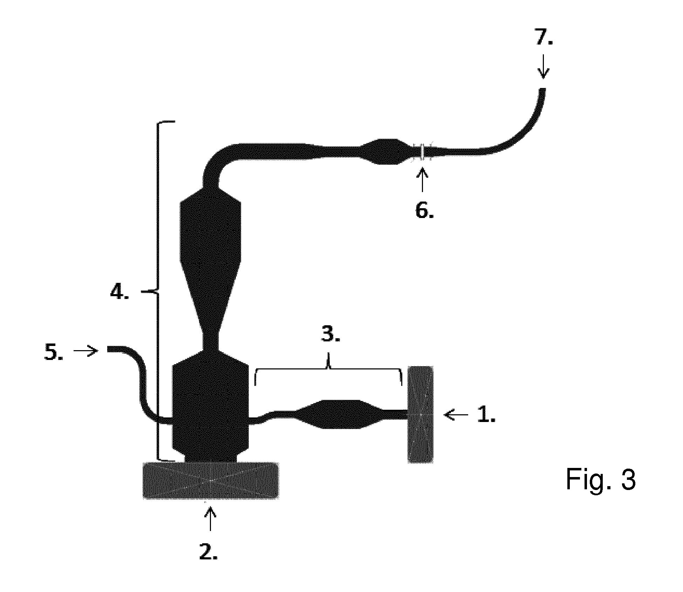

An exemplary implementation of the multi-harmonic combiner circuit, realized with microstrip transmission line components, is shown in Fig. 3. It comprises an impedance inverter 3, to which the main amplifier transistor 1 is connected and an output transformer structure 4, to which the auxiliary amplifier transistor 2, the impedance inverter 3, the DC bias feed 5 and the DC blocking capacitor 6 are connected. From the DC bias blocking capacitor the RF signal is then fed to the RF output 7.

The input drive functions that are used to generate the input signals for the respective amplifier cores from the input signal of the system are implemented as functions of frequency and instantaneous power. This serves two purposes.

1. Given the limitations of a practical design of the multi-harmonic output combiner, the real part of the fundamental frequency termination impedance of the main amplifier core in the low power region cannot be kept exactly constant over frequency. The residual variation will then result in a variation of maximum output power over frequency in the low power region. As the maximum power level of the low power region also defines the onset of the auxiliary amplifier cores operation, the latter has to be made frequency dependent in order to adapt to the variation of the real part of the main amplifier cores fundamental frequency termination impedance throughout the bandwidth.

2. In the high power region, when load modulation occurs, the ratios between the fundamental and second harmonic frequency components of the termination reactances deviate from their optimum value, as described before. This is inevitably related to the bandwidth limitation of the impedance inverter that is used in the output combiner. This deviation has to be reduced by using the input drive function to adjust the complex ratio between the amplifier cores output currents, especially with regard to the relative phase, over frequency. One way to acquire the optimum input drive functions for the high power region is via a multidimensional parameter sweep of frequency and the respective amplifier cores input amplitudes and relative phase(es), which can be performed in measurement and/or simulation, and from which results the optimum input drive functions can then be extracted by means of an optimization algorithm that takes into account efficiency, output power, linearity and other relevant criteria such as continuity and robustness of the solution.

Based on the proposed concept, it is possible to realize highly efficient power amplification over a relative BW of >30%. In contrast, today's Doherty amplifiers achieve efficient operation in a relative BW of ~10%.

Operation of the main and peak power amplifier at different output bias voltage levels is also compatible with the proposed structure. This will reduce the deviation from the optimum value of the ratio between fundamental and second harmonic frequency component reactances under load modulation and thus further enhance efficiency and BW of the power amplifier.

Thus, according to embodiments of the present invention, the bandwidth and efficiency limitations of RF power amplifiers are solved by using a novel type of multi-harmonic combiner in a Doherty-type amplifier, that provides a continuous multi-harmonic termination in the low power region while allowing wideband active load modulation in the high-power region, which is aided by frequency adaptive nonlinear drive functions, and optionally by using unequal supply voltages for main and auxiliary amplifier cores.

Hence, the embodiments of the present invention enhance the bandwidth of efficient RF power amplification for next generations of base stations and provide a solution to the ever increasing BW demands of RF power amplifiers.

It is noted that the embodiments and the present invention in general is not limited to the specific examples given above.

For example, in the above embodiments it was described that the multi-harmonic combiner circuit 15 provides continuous control of the terminations of amplifier cores for at least 3 harmonic frequencies. However, the invention is not limited to this. That is, it is possible to consider only one harmonic frequency (besides of the fundamental frequency), or two harmonic frequencies or even a higher number than three.

Moreover, according to the embodiment as described above in connection with Fig. 3, the multi-harmonic combiner circuit is realized with microstrip transmission line components. However, also other suitable hardware structures are possible.

According to a further aspect of embodiments of the present invention, an apparatus is provided which comprises a main amplifier core and at least one auxiliary amplifier core, means for splitting an input signal into a first signal for the main amplifier core and at least a second signal for the at least one auxiliary amplifier core according to frequency dependent nonlinear input drive functions, and means for combining output signals of the main amplifier core and the at least one auxiliary amplifier core, and to provide a continuum of optimum termination impedances of the main amplifier core for the fundamental frequency and at least one harmonic frequency over a predetermined bandwidth of operation, in a low power region, the low power region being defined by the at least one auxiliary amplifier core being inactive.

In the following, some modifications of the main aspects of the present embodiments are described.

According to a first modification, the output combiner is configured to allow for mutual load modulation between the amplifier cores in a high power region, which is defined by both amplifier cores being active, in such a way that efficient waveform shaping can be maintained under load modulation, that is, a deviation of the virtual termination impedances at the active devices (e.g., transistors) of the amplifier cores from the continuum of optimum termination impedances for the fundamental frequency component and at least one harmonic frequency component is minimized. That is, in this way average efficiency is maximized, also utilizing the degree of freedom that is given by choice of the frequency dependent nonlinear input drive functions.

According to a second modification, the output combiner is configured to minimize the deviation of the virtual termination impedances at the active devices of the amplifier cores from the continuum of optimum termination impedances for the fundamental frequency component and at least one harmonic frequency component by maintaining the deviation below a predetermined threshold.

According to a third modification, the output combiner comprises an impedance inverter provided for the main amplifier core and/or the auxiliary amplifier core, and is configured to implement the required continuous multi-harmonic termination conditions and ability to maintain these under load modulation by utilizing elements of a low-pass structure in the impedance inverter. That is, the output combiner implements the required continuous multi-harmonic termination conditions and ability to maintain these under load modulation by utilizing elements of a low-pass structure (such as but not limited to impedance steps in microstrip transmission lines) in the impedance inverter in the output combiner, in order to provide the desired impedance inversion at the fundamental frequency band and to absorb the parasitic elements of the transistor device and to minimize transmission of harmonic frequency components between the connected amplifier cores and to provide proper reflection phase for at least one harmonic frequency component at the main amplifier core.

According to a fourth modification, the output combiner comprises an output transformer circuit and is configured to implement continuous multi-harmonic termination conditions and ability to maintain these under load modulation by utilizing elements of a low-pass structure in the output transformer circuit. That is, the output combiner implements the required continuous multi-harmonic termination conditions and ability to maintain these under load modulation by utilizing elements of a low-pass structure (such as but not limited to impedance steps in microstrip transmission lines) in the output transformer circuit, in order to provide the required impedance transformation at the fundamental frequency band and to minimize the transmission of harmonic frequency components to the load connected to the apparatus and to provide proper reflection phase for at least one harmonic frequency component at the auxiliary amplifier core.

According to a fifth modification, the low-pass structure is implemented by impedance steps in microstrip transmission lines of a circuit structure of the apparatus.

According to a sixth modification, the input splitter is configured to provide the input drive functions for the respective amplifier cores as functions of frequency and instantaneous power in such a way that

     a) the power level of the onset of the auxiliary amplifier core's operation is made frequency dependent according to the residual variation of the real part of the load impedance of the main amplifier core load over frequency in the low power region and/or
     b) a complex ratio between output currents of the main and auxiliary amplifier cores in the high power region is controlled in such a way the deviation of virtual termination impedances at the active amplifier cores of the main and auxiliary amplifier cores from the continuum of optimum termination impedances for the fundamental frequency component and at least one harmonic frequency component is minimized.

According to a seventh modification, the input splitter of the sixth modification is configured to minimize the deviation of the virtual termination impedances from the continuum of optimum termination impedances for the fundamental frequency component and at least one harmonic frequency component by maintaining the deviation below a predetermined threshold.

According to an eighth modification, the input drive functions for the respective amplifier cores are realized by means of an analogue or a digital signal processing circuit. That is, the input drive functions of the input splitter can be realized in analogue radio frequency domain or by implementation in digital baseband, utilizing separate hardware branches for digital-to-analogue conversion and upconversion to the RF domain for each amplifier core.

According to a ninth modification, unequal drain bias voltages for the main and auxiliary amplifier cores are used, namely in such a way that the transformation ratio (i.e. characteristic impedance) of the impedance inverter(s) can be changed in such a way that the continuous multi-harmonic termination criteria can be fulfilled more easily and over a wider bandwidth, respectively.

It is to be understood that any of the above modifications can be applied singly or in combination to the respective aspects and/or embodiments to which they refer, unless they are explicitly stated as excluding alternatives.

For the purpose of the present invention as described herein above, it should be noted that

     -     devices, units or means (e.g. the above-defined apparatuses, or any one of their respective means or units) can be implemented as individual devices, units or means, but this does not exclude that they are implemented in a distributed fashion throughout the system, as long as the functionality of the device, unit or means is preserved;

- an apparatus may be represented by a semiconductor chip, a chipset, or a (hardware) module comprising such chip or chipset;
- a device may be regarded as an apparatus or as an assembly of more than one apparatus, whether functionally in cooperation with each other or functionally independently of each other but in a same device housing, for example.

It is noted that the embodiments and examples described above are provided for illustrative purposes only and are in no way intended that the present invention is restricted thereto. Rather, it is the intention that all variations and modifications be included which fall within the spirit and scope of the appended claims.

## Claims

1.  An apparatus comprising
    a main amplifier core and at least one auxiliary amplifier core, an input signal splitter connected to the input of the main amplifier core and the input of the at least one auxiliary amplifier core, and an output combiner connected to an output of the main amplifier core and an output of the at least one auxiliary amplifier core,
    wherein the input signal splitter is configured to split an input signal into a first signal for the main amplifier core and at least a second signal for the at least one auxiliary amplifier core according to frequency dependent nonlinear input drive functions, and
    the output combiner is configured to combine output signals of the main amplifier core and the at least one auxiliary amplifier core, and to provide a continuum of optimum termination impedances of the main amplifier core for the fundamental frequency and at least one harmonic frequency over a predetermined bandwidth of operation, in a low power region, the low power region being defined by the at least one auxiliary amplifier core being inactive.

2.  The apparatus according to claim 1, wherein the output combiner is configured to allow for mutual load modulation between the amplifier cores in a high power region, which is defined by both amplifier cores being active, in such a way that efficient waveform shaping can be maintained under load modulation, that is, a deviation of the virtual termination impedances at the active devices of the amplifier cores from the continuum of optimum termination impedances for the fundamental frequency component

nent and at least one harmonic frequency component is minimized.

3.  The apparatus according to claim 2, wherein the output combiner is configured to minimize the deviation of the virtual termination impedances at the active devices of the amplifier cores from the continuum of optimum termination impedances for the fundamental frequency component and at least one harmonic frequency component by maintaining the deviation below a predetermined threshold.

4.  The apparatus according to any one of the claims 1 to 3, wherein the output combiner comprises an impedance inverter provided for the main amplifier core and/or the auxiliary amplifier core, and is configured to implement the required continuous multi-harmonic termination conditions and ability to maintain these under load modulation by utilizing elements of a low-pass structure in the impedance inverter.

5.  The apparatus according to any one of the claims 1 to 4, wherein the output combiner comprises an output transformer circuit provided at the output of the output combiner, and is configured to implement continuous multi-harmonic termination conditions and ability to maintain these under load modulation by utilizing elements of a low-pass structure in the output transformer circuit.

6.  The apparatus according to claim 4 or 5, wherein the low-pass structure is implemented by impedance steps in microstrip transmission lines of a circuit structure of the apparatus.

7.  The apparatus according to claim 2, wherein the input splitter is configured to provide the input drive functions for the respective amplifier cores as functions of frequency and instantaneous power in such a way that

    a) the power level of the onset of the auxiliary amplifier core's operation is made frequency dependent according to the residual variation of the real part of the load impedance of the main amplifier core load over frequency in the low power region and/or
    b) a complex ratio between output currents of the main and auxiliary amplifier cores in the high power region is controlled in such a way that the deviation of virtual termination impedances at the active devices of the amplifier cores from the continuum of optimum termination impedances for the fundamental frequency component and at least one harmonic frequency component is minimized.

8.  The apparatus according to claim 7, wherein the input splitter is configured to minimize the deviation of the virtual termination impedances from the optimum termination continuum for the fundamental frequency component and at least one harmonic frequency component by maintaining the deviation below a predetermined threshold.

9. The apparatus according to claim 7 or 8, wherein the input drive functions for the respective amplifier cores are realized by means of an analogue or a digital signal processing circuit.

10. The apparatus according to any one of the claims 1-9, wherein unequal drain bias voltages for the main and auxiliary amplifier cores are used.

Fig. 1

Fig. 2

Fig. 3

**Europäisches Patentamt**
**European Patent Office**
**Office européen des brevets**

# EUROPEAN SEARCH REPORT

Application Number

EP 13 19 4771

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 193 857 B1 (WILSON RICHARD [US]) 5 June 2012 (2012-06-05) * column 1, line 47 - column 2, line 34 * * column 2, line 57 - column 6, line 31; figures 1-6 * | 1-10 | INV. H03F1/02 H03F1/56 H03F1/42 H03F3/195 H03F3/24 |
| X | EP 2 634 916 A1 (ALCATEL LUCENT [FR]) 4 September 2013 (2013-09-04) * paragraphs [0001], [0025] - [0031], [0033] - [0048]; figures 1,3a,3b,4,5 * | 1-10 | |
| X | US 8 593 219 B1 (ROOT LOREN F [US]) 26 November 2013 (2013-11-26) * column 1, lines 18-20 * * column 3, line 45 - column 6, line 4 * * column 6, line 52 - column 21, line 41; figures 2-8 * | 1-10 | |
| X | WO 2004/023646 A1 (FILTRONIC PLC [GB]; KHAN RASIB [GB]; ARCHER NICHOLAS [GB]; WALKER STUA) 18 March 2004 (2004-03-18) * page 2, line 30 - page 3, line 11 * * page 13, line 31 - page 19, line 32; figures 4A-E,6 * | 1-10 | TECHNICAL FIELDS SEARCHED (IPC) H03F |

The present search report has been drawn up for all claims

| Place of search | Date of completion of the search | Examiner |
|---|---|---|
| The Hague | 10 February 2014 | Goethals, Filip |

EPO FORM 1503 03.82 (P04C01)

**ANNEX TO THE EUROPEAN SEARCH REPORT**
**ON EUROPEAN PATENT APPLICATION NO.**                    EP 13 19 4771

This annex lists the patent family members relating to the patent documents cited in the above-mentioned European search report.
The members are as contained in the European Patent Office EDP file on
The European Patent Office is in no way liable for these particulars which are merely given for the purpose of information.

10-02-2014

| Patent document cited in search report | | Publication date | Patent family member(s) | Publication date |
|---|---|---|---|---|
| US 8193857 | B1 | 05-06-2012 | CN 102694507 A<br>DE 102012202870 A1<br>US 8193857 B1 | 26-09-2012<br>06-09-2012<br>05-06-2012 |
| EP 2634916 | A1 | 04-09-2013 | NONE | |
| US 8593219 | B1 | 26-11-2013 | NONE | |
| WO 2004023646 | A1 | 18-03-2004 | AU 2003263320 A1<br>GB 2393866 A<br>WO 2004023646 A1 | 29-03-2004<br>07-04-2004<br>18-03-2004 |

EPO FORM P0459

For more details about this annex : see Official Journal of the European Patent Office, No. 12/82

## REFERENCES CITED IN THE DESCRIPTION

**Patent documents cited in the description**

- WO 2012149976 A, Gustafsson, D., Fager, C.

**Non-patent literature cited in the description**

- **WU, D.Y. ; BOUMAIZA, S.** A Modified Doherty Configuration for Broadband Amplification Using Symmetrical Devices. *IEEE Transactions on Microwave Theory and Techniques,* 2012, vol. 60 (10), 3201-3213
- **CRIPPS, S.C. ; TASKER, P.J. ; CLARKE, A.L. ; LEES, J. ; BENEDIKT, J.** On the Continuity of High Efficiency Modes in Linear RF Power Amplifiers. *IEEE Microwave and Wireless Components Letters,* 2009, vol. 19 (10), 665-667

- **WRIGHT, P. ; LEES, J. ; BENEDIKT, J. ; TASKER, P.J. ; CRIPPS, S.C.** A Methodology for Realizing High Efficiency Class-J in a Linear and Broadband PA. *IEEE Transactions on Microwave Theory and Techniques,* 2009, vol. 57 (12